Europäisches Patentamt

European Patent Office

Office européen des brevets

(19)

(11) Publication number: **0 270 320 B1**

(12) **EUROPEAN PATENT SPECIFICATION**

(45) Date of publication of patent specification: **23.09.92**   (51) Int. Cl.5: **G01R 33/48**

(21) Application number: **87310510.0**

(22) Date of filing: **27.11.87**

(54) **Method of high-speed magnetic resonance imaging.**

(30) Priority: **03.12.86 US 937529**
**17.08.87 US 85568**
**16.10.87 US 109091**

(43) Date of publication of application:
**08.06.88 Bulletin 88/23**

(45) Publication of the grant of the patent:
**23.09.92 Bulletin 92/39**

(84) Designated Contracting States:
**AT BE CH DE ES FR GB GR IT LI LU NL SE**

(56) References cited:
**EP-A- 0 177 990**
**EP-A- 0 240 319**
**GB-A- 2 079 463**

**MAGNETIC RESONANCE IN MEDICINE, vol. 2, no. 5, October 1985, pages 437-452, Academic Press, New York, US; D.B. TWIEG: "Acquisition and accuracy in rapid NMR imaging methods"**

**JOURNAL OF MAGNETIC RESONANCE, vol. 29, 1978, pages 355-373, Academic Press, Inc., GB; P. MANSFIELD et al.: "Biological and medical imaging by NMR"**

**SPIE PROCEEDINGS, vol. 593, Medical Image Processing 1985, pages 6-13; P. MARGOSIAN et al.: "Faster MR imaging methods"**

**RADIOLOGY, vol. 161, no. 2, November 1986, pages 527-531, US; D.A. FEINBERG et al.: "Halving MR imaging time by conjugation: demonstration at 3.5 kG1"**

**MAGNETIC RESONANCE IN MEDICINE, vol. 2, no. 3, June 1985, pages 203-217, Academic Press, Inc., New York, US; C.M.J. VAN UIJEN et al.: "Fast fourier imaging"**

(73) Proprietor: **ADVANCED NMR SYSTEMS, INC.**
**30 Sonar Drive**
**Woburn, MA 01801(US)**

(72) Inventor: **Rzedzian, Richard R.**
**9 Middle Street**
**Lexington Massachusetts(US)**

(74) Representative: **Skone James, Robert Edmund et al**
**GILL JENNINGS & EVERY 53-64 Chancery Lane**
**London WC2A 1HN(GB)**

EP 0 270 320 B1

## Description

The present invention relates to magnetic resonance imaging (MRI) techniques and, more particularly, to a technique for imaging at speeds of less than about 100 milliseconds.

For various reasons, it would be desirable to provide a technique for magnetic resonance imaging (MRI) in which images can be obtained in a very short period of time. Primary among the factors currently limiting the rate of growth of MRI in the diagnostic imaging marketplace are concerns relating to its cost-effectiveness, and its limited applicability to the study of organ systems subject to significant involuntary physiological motion, especially of the heart. Both of these problems (especially the latter) would be alleviated if the long data acquisition times (typically several minutes) could be decreased. This would reduce the total patient study time, increase patient throughput and hence optimize cost-effectiveness. If the total scan time is reduced to a small fraction of the cardiac period, motion artifacts due to all physiological motions including that of the heart, can be avoided.

High-speed whole body biological images obtained to data have suffered both from poor spatial resolution and from poor signal-to-noise ratio (SNR). (As used herein, "high-speed" signifies about 100 milliseconds for acquisition of a complete, tomographic proton image). This low quality is, in part, a reflection of the relatively low magnetic field strength used. However, it is known that SNR increases approximately linearly with field strength, and thus higher quality images can, in principle, be obtained at higher field strengths.

Several problems are confronted in implementing high-speed imaging at high-field strengths, and the invention described herein provides solutions to these problems.

One major problem is using high magnetic fields for magnetic resonance imaging is that inhomogeneities in the magnetic field are, for practical purposes, unavoidable, and can introduce phase and geometrical distortion into magnetic resonance images of an object under investigation. Such magnetic inhomogeneities are introduced from two distinct sources. First, a static magnetic field has an inherent non-uniformity which typically varies in proportion to the magnetic field strength. As a practical matter, such inhomogeneity is considered unavoidable in the static magnetic field, since to eliminate it would be unduly difficult and unduly expensive. Secondly, the magnetic susceptibility of an object being imaged provides an object dependent additional contribution to the magnetic inhomogeneities in the system.

Additionally, at high frequencies the RF field is attenuated and subject to phase shifts when penetrating a weakly conductive object, such as a human body. This effect is certainly in evidence at 85 MHz, which is the proton resonance frequency at around 2 Telsa.

A further major problem in imaging at high field strengths is the proton "chemical shift" effect. This problem arises because the signal from any given point in the image may, in general, contain essentially two closely-spaced frequencies; one from water protons and one from lipid protons. The imaging procedures used in MRI place signals deriving from particular volume elements into corresponding picture elements in the final image based on their unique frequencies; hence, the two distinct frequencies deriving from lipid and water in the same volume element of tissue will be incorrectly placed into different picture elements. This results in two superimposed images. This problem is usually solved at lower field strengths, or for slower imaging methods, simply by increasing the strength of the magnetic field gradients which provide the spatial discrimination in the image, to the extent that the bandwidth they impose per picture element is substantially greater than the frequency separation of the proton resonances of fat and water. In the case of high-speed imaging, the uses of such high bandwidths per picture element would be prohibitively difficult to implement. Furthermore, the bandwidth would necessarily have to increase with field strength, thereby reducing any SNR increases to a square root of field strength dependency.

GB-A-2079463 describes a method of deriving image information using nuclear and magnetic resonance signals including the steps of slice selection wherein a rf pulse (90°) is applied to the object to be imaged together with a slice selection gradient (Gy+), a rephasing gradient pulse applied in the same direction (Gy-), an alternative application (in time) of a read out gradient (Gx) (switched from positive to negative values to produce a series of echo signals) and a phase encoding gradient (Gz) applied during each successive reversal of the read out gradient Gx, data acquisition during the read out gradient and image reconstruction. The application of the read out gradient may be discontinuous or continuous. If this method was applied using high field strength in the order of 0.5-5 Tesla, significant problems occur with the phase of the image.

Accordingly, to overcome the foregoing problems present in high-speed magnetic resonance imaging with high magnetic fields, applicant has devised a method for rapidly obtaining magnetic images from an object. The object is placed in a static magnetic field along a first axis, conventionally referred to herein as the "z" axis. The magnetic field along the "z" axis has an intensity in the range from about 0.5 to 5 Tesla.

Nuclear spins are excited in an image area in a selected plane of the object, by superimposing on the static magnetic field in the z direction a first gradient field, termed a slice-selection gradient, and simultaneously applying a spectrally-tailored radio frequency (RF) excitation pulse, whereby free induction decay signals are produced by the excited nuclear spins. During the RF excitation, dephasing of nuclear spins may occur across the width of the selected plane, and rephasing of the nuclear spins is required. Rephasing may be achieved either by reversing the first gradient field or by reapplying a similar first gradient waveform following the application of a 180° pulse (to be discussed below).

Second and third magnetic gradients, termed phase-encoding and readout gradients, respectively, are applied in the x and y directions, respectively. As is conventional, the x, y, and z directions are assumed to be mutually orthogonal. The selected area is in the x-y plane, which is commonly referred to as the transverse plane.

The time-varying phase-encoding and readout gradients perform the function of changing the phases of the temporal nuclear signals in a spatially variant manner, i.e., determining the points in the spatial frequency domain which are sampled at specified times during the acquisition of data. The resulting trajectory of sample points in k-space is known as the k-trajectory.

The decoding process involves several steps of initial processing followed by the operation of two dimensional Fourier transform, and yields a discrete image which is an estimate of the original spatial distribution.

In order to set the point in k-space at which sampling will begin, an encoding sequence occurs prior to sampling. Thereafter, a radio frequency signal is applied to the object to rephase any of the subject nuclear spins that have become dephased due to non-uniformities in the static magnetic field. Next, the data are sampled by a sequence in which phase encoding and readout gradients are alternately applied. In a preferred embodiment of the invention, the readout gradient is applied as a continuous sinusoidal wave, resulting in a slight overlap between the phrase-encoding and readout gradients. The entire sampling sequence, including the encoding period and the application of the radio frequency pulse, occurs with an imaging period of less than about 100 milliseconds.

The dramatic improvement in scan time using the above-described technique is achieved only at the expense of a reduction in signal-to-noise ratio (SNR) and/or spatial resolution. In circumstances where body motion is not a problem, this reduction may not be acceptable. In such situations, it is preferable to spend more time acquiring data and regain the spatial resolution. The following variants of the above-described high speed imaging technique have therefore been developed to provide a set of choices among spatial resolutions, total study time, and SNR, which the physician can select and tailor to the particular clinical application.

If there were no phase distortions introduced as a result of magnetic field non-uniformities, or by any other cause, it would be sufficient that the k-trajectory covered lines only in the positive or negative half of k-space. Corresponding data lines sampled in the opposite half of k-space would contain identically conjugated data, and hence only yield data redundancy. However, in the presence of phase distortions, corresponding data lines in opposite halves of k-space are not identical.

It has been discovered that information derived from the extension of the sampling trajectory to more than half of k-space may be used to compensate for phase errors. The extension of sampling required depends on the extent of phase errors introduced. For example, if phase errors vary only slowly over the image (i.e., the errors have low spatial frequencies), relatively little additional trajectory needs to be sampled. By sampling only those additional lines necessary for adequate phase correction, the total acquisition time is minimized, and the time of initiation of data sampling following the initial excitation pulse-(s) is minimized. This latter consequence is desirable in that signal decay as a result of $T_2$ is thereby minimized. Furthermore, the signal-to-noise (SNR) of the output is optimized, provided that the SNR loss due to $T_2$ decay is greater than the SNR loss resulting from the acquisition of fewer data lines.

In one variant of partial k-space imaging, a partial acquisition of k-space is taken in either of the x or y dimensions. The sampling trajectory in a partial scan is less than 100%, but preferably extends over more than half of k-space. The information acquired from the extension of the sampling trajectory over the origin is used to compensate for any phase errors introduced. Since each line of k-space requires approximately 400 microseconds elimination of $k_x$ lines in a partial $k_x$ acquisition saves imaging time.

A partial k-space acquisition can be conducted so that the same number of points are collected as in a previous full k-space acquisition, thus increasing spatial frequency response, while maintaining signal bandwidth. This technique therefore produces a higher resolution image in "one shot", but with a lower SNR.

In a further variant of the invention, two, four or more partial acquisitions are performed on different portions of k-space with an inter-acquisition delay of TR. The acquired portions are pieced together in a k-

3

space patchwork or "mosaic" prior to Fourier transformation. The coverage of k-space in this "Mosaic Scan" technique can therefore be 100%, but multiple acquisitions are required. The SNR loss is partially regained because (a) all of k-space is filled; (b) because the low spatial frequencies are effectively signal-averaged; and (c) several acquisitions are now contributing to one image.

In order to eliminate the chemical shift problem referred to previously, two preferred embodiments are described. In one embodiment, prior to slice-select, a narrow-band "suppression" pulse of RF field is applied, followed by a pulse of magnetic field gradient substantially greater in spin dephasing power than any subsequent gradient in the imaging sequence. This effectively eliminates signals from one of the chemical moieties, lipid or water. In another embodiment, the 180° refocussing pulse is selected such that its frequency spectrum and "off-resonance" effect combine so as to preclude rephasing of one or other of the moieties.

Other objects, features and advantages of the invention will become apparent from the following description of the preferred embodiments of the invention, considered in connection with the accompanying drawings and appended claims.

Figure 1 is a simplified view of an object being imaged positioned within a magnet, illustrating the conventional spatial coordinate system x, y, z for the magnetic gradients referred to throughout the specification and claims;

Figure 2 is a preferred pulse sequence in accordance with the present invention;

Figure 3 is the graph of spatial or Fourier domain frequences of the image of the object in Figure 1 being investigated;

Figure 4 shows a suppression pulse sequence applied prior to slice-select to eliminate the chemical shift problem.

Figure 5 is an enlargement of the acquisition pulse sequence shown in Figure 2, but with the readout gradient applied as a continuous sinusoidal wave.

Fig. 6 shows the extent of coverage of the spatial frequency domain in a partial $k_y$ scan;

Fig. 7 shows the initial trajectory and coverage of the spatial frequency domain in a 2-Tile Mosaic Scan.

Figs. 8A-8C show the sequential coverage of the spatial frequency domain in a 2-Tile Mosaic Scan.

Fig. 9 shows the pulse sequence and signal for the 2-Tile Mosaic Scan of Figs. 7 and 8A-8C.

Fig. 10 shows the initial trajectory and coverage of the spatial frequency domain in a 4-Tile Mosaic Scan.

Fig. 11 shows the initial trajectories and coverage of the spatial frequency domain in a 4-Pulse MESH Scan.

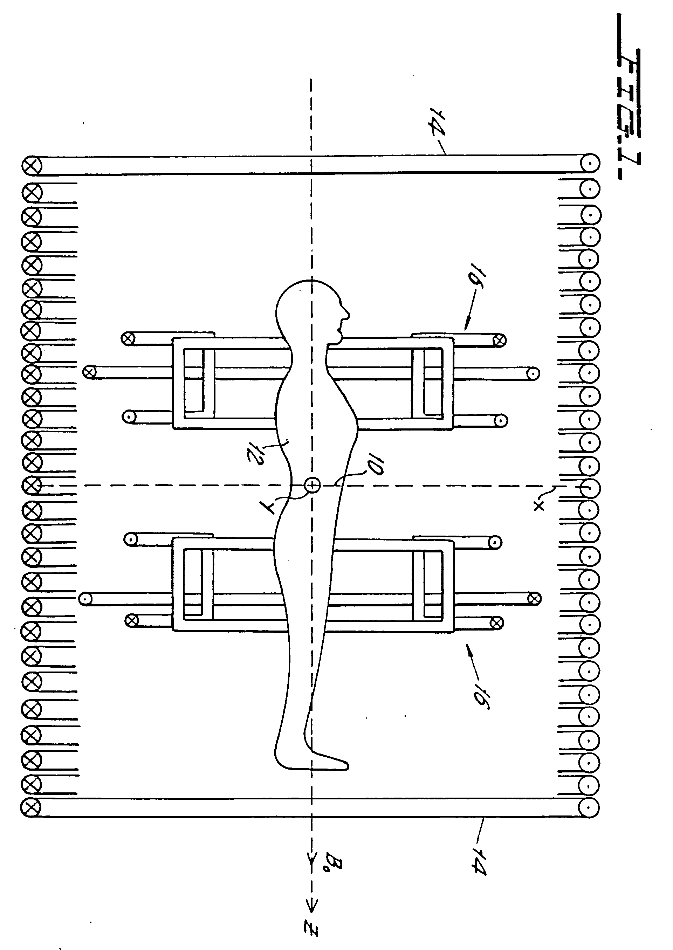

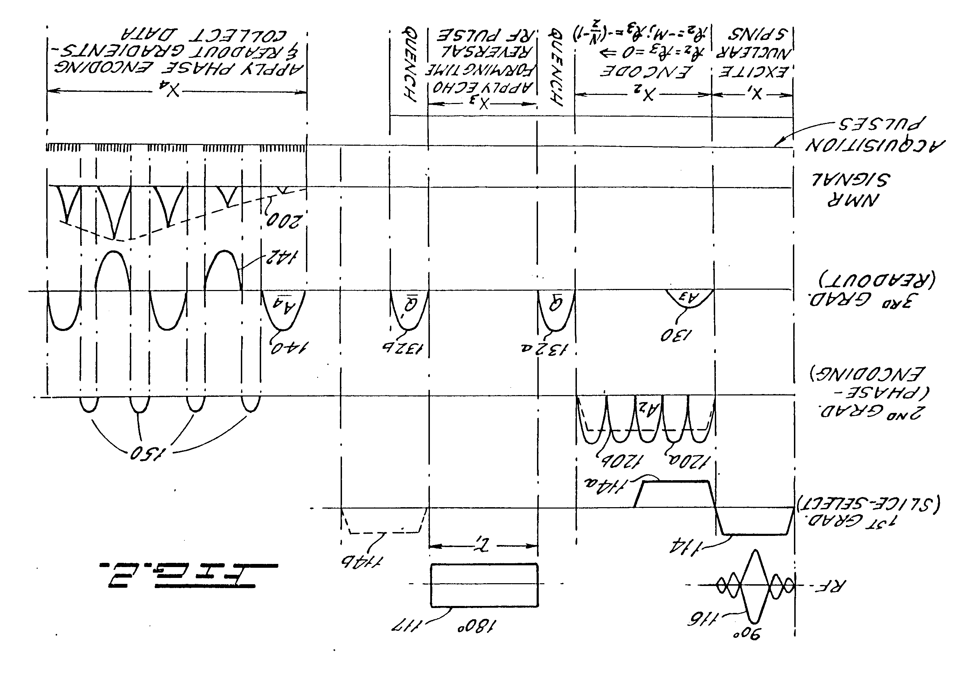

Referring first to Figure 1, it is desired to obtain a magnetic resonance (MR) image of a selected area 10 within an object 12, such as a human body, positioned within a magnet 14. As shown in Figure 1, selected area 10 exists within a plane defined by the orientation of the applied field gradients in the x, y, and z directions which are generated by the coil structure 16. For the purpose of the following description, as is the usual convention, the direction of the static magnetic field $B_o$ is taken to define the z-axis. Also by way of example, it is assumed that the first gradient field (the slice-selection gradient) is applied in the z-direction, the second gradient field (the phase encoding gradient) is applied in the x-direction; and the third gradient field (the readout gradient) is applied in the y-direction. The x, y and z directions are taken to be mutually orthogonal. Thus, the selected area 10 falls in the x-y plane. For a human subject lying with its longitudinal axis parallel to the z-axis, this x-y plane is commonly referred to as the transverse plane.

Obviously, the above-recited coordinate assignment of the first, second and third gradient fields as applied in the x, y and z directions is not exclusive. For example, a defined area in the x-z or y-z planes may be selected by assuming that the first gradient field (slice-selection gradient) is applied in the y or x directions respectively, with the second (phase-encoding) and third (readout) gradients applied in the x and y or y and z direction respectively. The defined area will then be a coronal or sagittal plane. Furthermore, in general, the first, second and third gradients need not necessarily lie along any of the directions x, y, or z defined above. Whilst maintaining their mutual orthogonality, the said first, second and third gradients can be rotated to point along a transformed coordinate set $x_1$, $y_1$, and $z_1$, in which case arbitrarily oriented "oblique" planes may be selected and imaged from a viewpoint perpendicular to the plane. Finally, the first, second and third gradients need not necessarily be mutually orthogonal, in which case, for instance, arbitrarily oriented oblique planes may be selected and then obliquely imaged, i.e., from a viewpoint oblique to the plane. These variations of coordinate assignments are well-known to those skilled in the art.

For the particular coordinate assignment of gradient fields recited above, the gradients $G_x$ and $G_y$ and $G_z$ are defined by:

$$G_x = \frac{dB}{dx}z \quad ; \qquad G_y = \frac{dB}{dy}z \quad ; \qquad G_z = \frac{dB}{dz}z$$

The object undergoing investigation is at all times subjected to a continuous magnetic field $B_o$ along the z-axis. The level of magnetic field chosen must be sufficiently high that an adequate signal-to-noise ratio (SNR) is obtained, with an adequate spatial resolution, in the final image. Further, the requirement of adequate spatial resolution places demands on the strength of the phase-encoding and readout gradients, the latter placing concomitant demands on the required signal bandwidth of the radio-frequency antenna which collects the signal which, in turn, has to possess as high a quality factor (Q) as possible for optimal SNR.

For adequate SNR's in the range of approximately 10:1 to 100:1, and adequate spatial resolutions in the range of approximately 5 mm to 1 mm for an adult human body, using the applicant's method these constraints require a field strength in the range of about 0.5 to 5.0 Tesla. In the preferred embodiment of the invention, the field strength is 2.0 Tesla. This level of magnetic field is sufficiently high that non-uniformities in the field are introduced by the subject itself which must be compensated for by techniques described hereafter. The high magnetic field advantageously allows spectral resolution of signals from specific molecular compounds to avoid the chemical shift problem. Techniques for performing the spectral resolution are also discussed hereinafter.

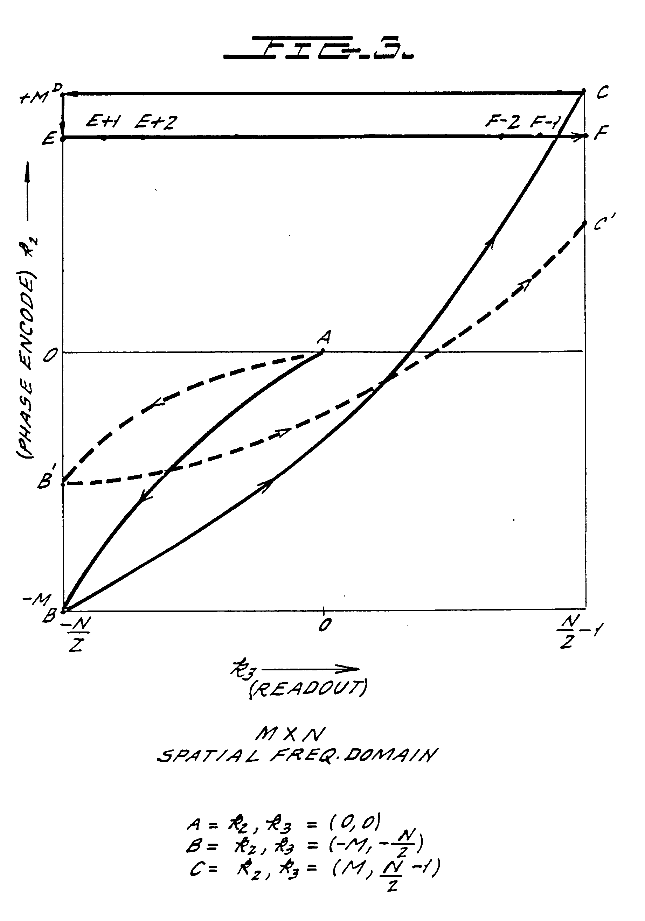

Turning now to the pulse sequence shown in Figure 2, reference is made to the time intervals $x_1$ through $x_4$. In interval $x_1$, nuclear spins are excited in selected area 10 within a plane of the object undergoing investigation. This is accomplished by superimposing on the static magnetic field the first gradient field, for example, $G_z$, preferably having waveform 114. A spectrally-tailored 90° radio frequency (RF) pulse 116 is applied during steady application of the gradient $G_z$. RF pulses of less than or greater than 90° can also be applied, but for these purposes a 90° pulse is preferred. During this RF excitation, dephasing of the nuclear spins may occur across the width of the selected plane, and subsequent rephasing is necessary in order to obtain maximum signal amplitude and minimum phase distortion. Such rephasing is achieved by reversing the first gradient field as indicated in the waveform 114 at 114a. Alternatively, rephasing may be delayed, for example to time interval $x_4$ (after application of the 180° pulse, described hereinafter), in which case a waveform of the type shown at 114b may be employed. Other suitable waveforms for $G_z$ and various spectral tailoring schemes for the 90° pulse will be readily apparent to those skilled in the art.

An encoding sequence occurs during the time interval $x_2$. Encoding the signal has the effect of determining the point (or, in the pulse sequence of Figure 2, the conjugate point) in k-space from which data sampling will commence. The particular waveforms 120a, 120b and 130 suggested are not exclusive; many suitable waveforms for the second and third gradients ($G_x$ and $G_y$) will be apparent to those in the art. For example, the waveform of the second gradient may be trapezoidal, as shown at 120b. Alternatively, a similar area $A_2$ may be swept out by multiple, short, gradient pulses, of the same waveform shape as required in time period $x_4$ of the pulse sequence. The fundamental parameter is the area under the waveforms represented by $A_2$ for the second gradient field and $A_3$ for the third gradient field, since these areas are related mathematically to the k-space trajectory. Thus, while practical considerations dictate particular waveforms in time period $x_4$, the waveforms used in the encoding period $x_2$ may be of any one of a number of suitable shapes.

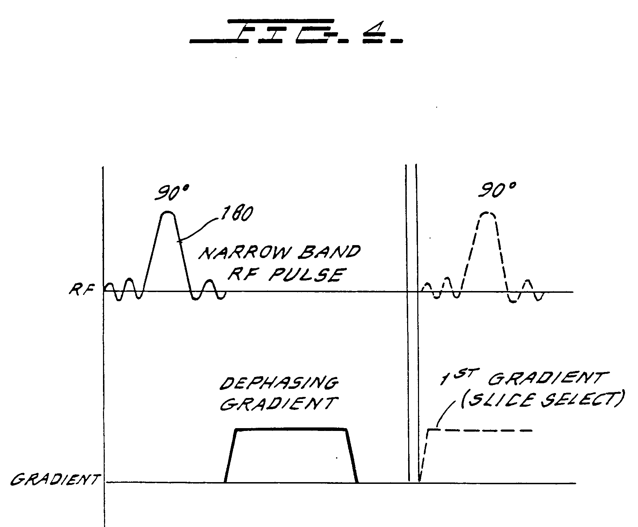

Figure 3 shows a representation of k-space, i.e., the spatial frequency domain, where lines over which the k-trajectory is sampled correspond directly to discrete spatial-frequency coordinates. The vertical axis, $k_2$, represents the spatial frequency coordinates corresponding to the second gradient field (phase encoding). The horizontal axis, $k_3$, represents the spatial frequency coordinates of the third gradient field (readout). The time $t = t_o$ immediately following the RF excitation period $X_1$ and prior to any encoding defines the origin $k_2 = k_3 = 0$ of the k-trajectory in k-space, and is denoted as A in Figure 3. The encoding sequence in time interval $x_2$ maps out a trajectory, the time dependent of which depends on the actual waveform shapes 120a, 120b and 130. However, the position of the trajectory at the end of encoding period $x_2$ depends only on the areas $A_2$ and $A_3$, and these can be set arbitrarily. One particularly preferred setting of the areas $A_2$ and $A_3$ is such that the position of the trajectory at the end of the pre-encoding period $x_2$ is $k_2 = (k_2)i = -M$ and $k_3 = (k_3)j = -N/2$, denoted B on Figure 3.

Referring again to Figure 2, during the time interval $x_3$, an RF pulse 117 is applied to the object. The main purpose of RF pulse 117 is to rephase nuclear spins that have become dephased due to non-uniformities in the static magnetic field $B_o$. When measured as a fraction of the main magnetic field strength, such non-uniformities are similar for most typical magnets which generate fields in the range 0.5 to 5.0 Tesla, i.e., typically the non-uniformities are between 1 and 10 parts per million of the applied field strength $B_o$ over the region of the object being imaged. In absolute terms, therefore, the non-uniformity is more severe at higher fields. To accomplish the rephasing functions of the RF pulse 117, such pulse is preferably configured as a 180° pulse.

The use of the 180° pulse 117 is conventionally known to result in a mirror image or spin-echo of the original MR signal which resulted following the initial 90° RF pulse 116. Such echo effect is illustrated by the dashed line 200 in Figure 2, which grows and decays with the time constant $T_2^*$ (T-two-star). $T_2^*$ is a time constant for loss of phase coherence among nuclear spins in a non-uniform magnetic field, and is defined in the art.

As an incident to the use of 180° RF pulse 117 to rephase the nuclear spins selected in the plane of interest in the object, a trajectory from B to the conjugate position C is effected in k-space, where C is defined by the spatial frequency coordinates $k_2 = (k_2)i = +M; (k_3)j = +N/2$. Since the RF field generated by a typical RF transmitting coil is not perfectly uniform, there is the possibility that the actual pulse angle of the RF pulse 117 varies over the volume occupied by the object. In particular, it may be inaccurate in positions outside of the selected plane (which did not receive the initial 90° exciting pulse 116), as compared to positions in the plane. Nuclei spins outside of the selected plane, not having experienced the prior 90° pulse 116, will generate unwanted signal if the pulse angle of the RF pulses 117 is not exactly 180°. In order to eliminate this unwanted signal, equal pulses of gradient may be applied to each side of the 180° RF pulse 117; for example, gradient pulses generated by the third gradient may be applied, denoted 132a and 132b in Figure 2. If the areas Q and $Q^1$ under the gradient waveforms 132a and 132b are substantially identical, which is the required case, no net phase encoding will be conferred upon the spins within the plane of interest after completion of the waveform 132b because of the 180° reversal applied between the waveforms. However, signal generated outside of the selected plane by RF pulse 117, as a result of RF field non-uniformity, will be dephased by pulse 132b, and the remainder of the pulse sequence is designed such that the rephasing of these particular spins will not occur. This procedure effectively eliminates any "out-of-plane" signal in a reasonably extended sample with adequate homogeneity.

As an alternative, or in addition to the procedure just described, it is possible to use the gradient pulse 114b instead of 114a. In this case, the dephased spins within the slice are rephased only after the 180° RF pulse by gradient 114b, which at this point in the pulse sequence also dephases any signal generated outside the selected plane by RF pulse 117.

In a further embodiment of the invention, the 180° RF pulse is omitted and all echoes are formed by the application of gradients alone. In this case, referring to Figure 3, there is no trajectory from point B to point C, and instead, the traverse of k-space now commences from point B, and proceeds in the positive direction $k_2$. In the case of the partial filling of k-space (described later), the traverse now begins from point B'. Note that the first traversal along $k_3$ is in the positive $k_3$ direction, which is opposite to the first traversal of the case in which the 180° pulse is applied. This means that the third (readout) gradient must be applied in the opposite polarity. Also, since the traversal of k-space proceeds in the positive $k_2$ direction, the second (phase-encoding) gradient must be applied in a polarity opposite to that applied in the case which contains the 180° pulse.

In accordance with an important aspect of the present invention, complete data for a MR image is acquired in less than about 100 milliseconds and preferably within a time less than the characteristic decay time $T_2$ (T-two) of the nuclei selected in the plane of interest. Data acquisition in such a short time period has been found necessary for reducing to virtually zero any deleterious effects in the image due to motion of bodily organs such as the heart. Such rapid data collection is accomplished in interval $x_4$ in the pulse sequence of Figure 2 by alternately applying the second (phase-encoding) and third (readout) gradients to the object being imaged.

The waveform shape 140 of the readout gradient cannot be trapezoidal as had been suggested by the prior art literature. The use of a trapezoidal readout gradient will cause severe problems because the electrical inductance of the gradient producing coils is necessarily large in order to achieve the magnitude of gradient fields required. Consequently, the rise times of the gradient waveforms, which have to be sufficiently rapid to acquire the necessary data in the time frame discussed above, can only be achieved in practice by the use of impractical amounts of power. The preferred method for generating these rapidly-varying gradient fields is described in U.S. Patent No. 4,628,264, issued December 9, 1986, assigned to the same assignee as the present invention, and yields gradient waveform segments 132a and 132b which are approximately sinusoidal in shape.

With continuing reference to Figure 2, if the area $A_3$ under the gradient waveform 130 is made as closely as possible to half the area $A_4$ under waveform 140, a rephasing of the nuclear signal in the direction of the third gradient field will occur, and maximum rephasing of the signal in this direction will occur approximately at the peak of the gradient waveform 140. The signal may be sampled in time in such a fashion that each sample point is acquired after an equal area is swept out by the gradient waveform 140, and hence equal increments of net phase rotation are incurred by the nuclear spins. This non-linear sampling scheme, in which the time dependence of the sampling "comb" is constrained to match exactly the gradient waveform shape 140, has been described in the art. See, for example, U.S. Patent No. 4,509,015 to Ordidge and Mansfield entitled "Nuclear Magnetic Resonance Methods".

Other schemes for sampling and processing the data are, of course, also possible. In one such scheme, the data are acquired with equal time increments between the sampling points and rapidly enough to adequately describe the highest frequency components of the signal. Subsequently, the data may be processed, for instance, by interpolation and resampling, such that the steps in k-space are approximately in equal increments along $k_3$. An oversampling of the data along $k_3$ may be necessary in both equal and non-equal time interval cases in order to compensate for any instrumental effects. Further, because the gradient shape may vary throughout space due to eddy current effects, no single set of non-equal sampling intervals may be adequate to accurately estimate the diffraction pattern of the object. In such a case, the spatially dependent gradient shapes can be measured in advance in order to provide information to compensate for this effect.

At the end of sampling the spin echo generated during the gradient waveform 140, the k-trajectory has moved from $k_2, k_3 = (M, N/2 - 1)$ to $k_2, k_3 = (M, - N/2)$, i.e., to point D on Figure 3. In particular, non-linear sampling during data acquisition is such that the k-trajectory is sampled in equal increments along the $k_3$ line from C to D. (Note that maximum rephasing in the third gradient direction occurs as the trajectory passes though the $k_3 = 0$ line.)

Thus sampling is performed at points on the trajectory along points $k_3$ such that the steps are

$$\Delta k_3 = \frac{2\pi}{X_3} = \gamma \int_{t}^{t_{i+1}} G_3(t) \, d(t),$$

where $X_3$ is the spatial field of view in the third direction, $G_3$ is the strength of the third gradient, and $t_i$ to $t_{i+1}$ is the interval between the ith and $i+1$ sample points.

A phase-encoding waveform 150 is then applied in the second direction, causing the k-trajectory to move to point E in Figure 3. The step $\Delta k_2$ is given by

$$\Delta k_2 = \frac{2\pi}{X_2} = \gamma \int_{t_1}^{t_2} G_2(t) \, d(t),$$

where $X_2$ is the spatial field of view in the second direction, $G_2$ is the strength of the second gradient, and $t_2$-$t_1$ is the interval of application. No data sampling is performed during this period. The application of the next readout gradient pulse 142, which is applied with the same magnitude but in opposite polarity with the preceding gradient waveform 140, causes another rephasing of the nuclear signal in the direction of the third gradient at the position corresponding to $k_3 = 0$ on Figure 3. Sampling of the data in the manner described above maps out a close to parallel trajectory in k-space from E to F in Figure 3, displaced from the first trajectory from C to D by one phase-encoding step k in the second gradient direction. Subsequent repeated applications of the waveforms of the second and third gradient fields maps out a k-trajectory raster completely covering k-space.

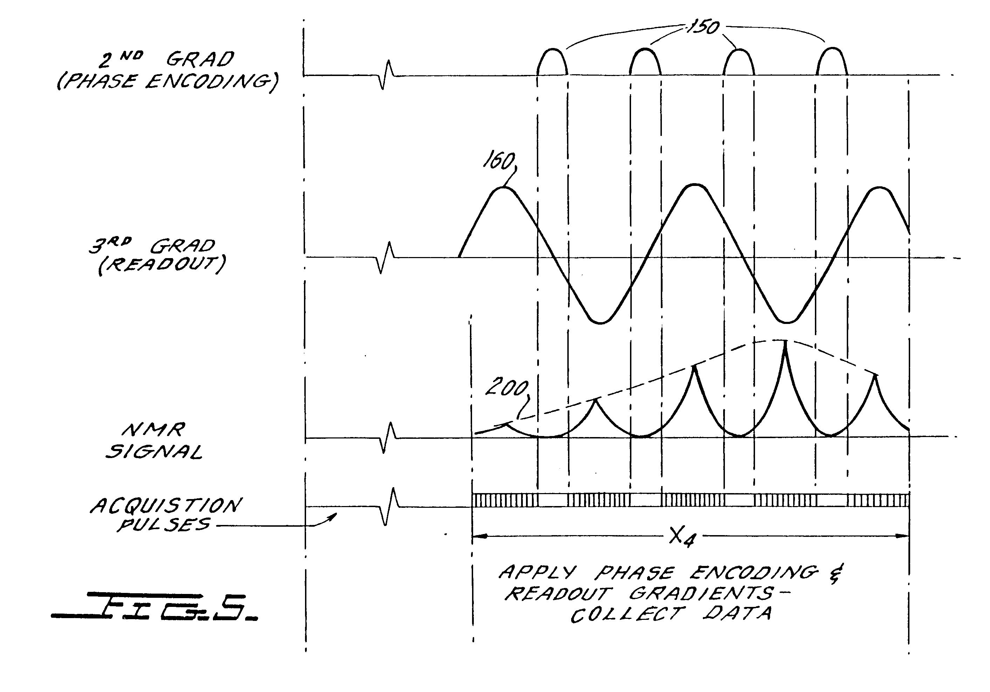

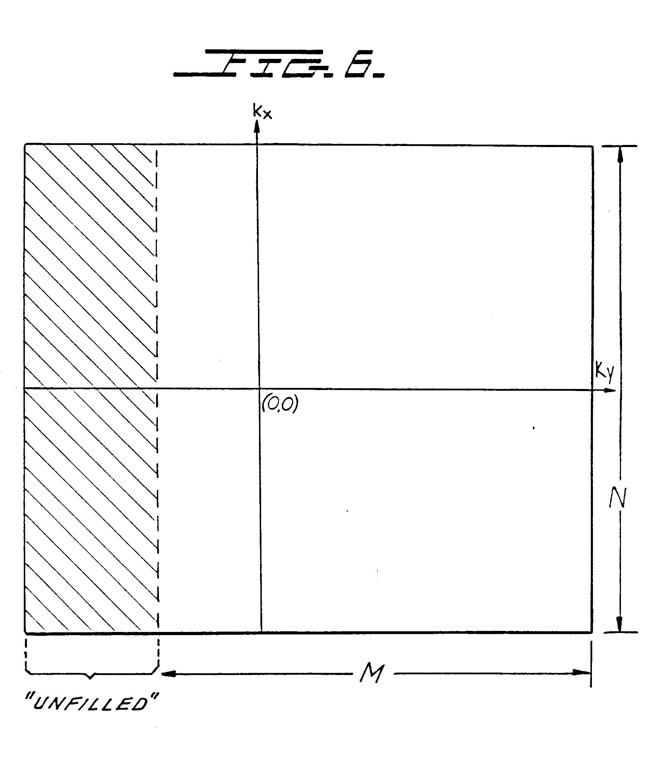

The readout gradient 140 shown in Figure 2 is discontinuous; i.e., the gradient 140 waits at zero amplitude while a short pulse 150 of phase-encoding gradient is applied. In a preferred embodiment, shown in Figure 5, the readout gradient is applied as a continuous sinusoidal wave 160. Phase-encoding gradients 150 are then applied as before, but centered approximately about the points at which the readout gradient 160 crosses through zero.

For short pulses of phase-encoding gradient 150, the few data points which are collected while both phase-encoding and readout gradient are on can be deleted prior to Fourier transformation with almost no image degradation. The advantages of this embodiment are that the acquisition time is shorter because there are no gaps in application of readout gradient. Therefore, motion artifacts from rapidly moving structures are reduced still further; the extent of $T_2$ and $T_2^*$ decay over the acquisition is reduced; and the echo envelope 200 may be centered closer to the initial 90° excitation pulse 116, thereby reducing signal loss which results from $T_2$ decay. Alternatively, the shorter acquisition means that more $k_2$ lines may be acquired in the same time as required in the original, non-continuous readout waveform case. In addition, the implementation of a continuous gradient waveform is conceivably technically simpler to achieve from a gradient waveform point of view, and the eddy current compensation may be simpler or more readily achievable.

Following the complete (approximately 100 millisecond) acquisition, the k-trajectory ends at point B on Figure 3. Note that as the trajectory raster passes through $k_2 = 0$, maximum refocussing of the spins in the second gradient direction occurs, and at the point at which the trajectory crosses the origin of k-space, point A on Figure 3, maximum refocussing in both the second and third gradient directions occurs, and a spin-echo signal approaching maximum amplitude is generated.

From Figure 3 it may be seen that every alternate k-trajectory in the $k_3$ (or readout) direction is reversed. This is because of the need to reverse the third gradient in order to appropriately cover k-space. Consequently, the traverse across every alternate line in k-space must be reversed; this operation is equivalent to a time reversal of the appropriate data. Thus the trajectory shown in Figure 3 of E, E + 1, E + 2 . . . F-2, F-1, F becomes F, F-1, F-2 . . . E + 2, E + 1, E. This procedure is repeated for every alternate line of k-space.

Additionally, it is desirable to correct the baseline offset of the data which may be generated by undesirable instrumental effects. This may be accomplished by sampling data from the quadrature output of the receiver immediately before application of the first RF pulse of the imaging sequence. Phase correction and filtering may also be necessary before the data are Fourier transformed. These steps are generally known in the art and do not require explanation.

The image is subsequently generated by performing a two-dimensional Fourier transform of the k-space data, which estimate in a discrete manner the diffraction pattern of the object. In particular, it should be noted that the image consist of the superposition of the Fourier transforms of the odd echoes (the 1st, 3rd, 5th, . . . etc., acquired lines of k-space) with the even echoes (the 2nd, 4th, 6th, . . . etc., acquired lines of the k-space). Consequently, it is possible to separately transform the odd and even echoes into partial images and modify them before combination. In fact, these processing steps may be desirable for instrumental reasons under certain circumstances. The modification of the partial images involves changing the phase and amplitude to eliminate any instrumentally induced errors.

Under certain circumstances, an MR image can be generated from a spatial frequency data set which is only partially complete in terms of its k-space coverage. In general, any phase-errors which arise as a result of magnetic field non-uniformities (due to the imperfections in the main magnet, magnet susceptibility variations within the object under study and radio frequency field variations due to penetration effects and eddy currents) can be compensated for by acquiring the complete spatial frequency data set (full k-space acquisition) as described above with reference to Figures 2 and 3. However, it is possible to correct such phase errors even in the case where less than a complete acquisition is performed if the phase errors vary over the image only with low spatial frequencies.

For such partial k-space acquisitions, the pulse sequence of Figure 2 is modified as follows. During the encoding period $x_2$, the area of waveform 120a or 120b is reduced such that the k-trajectory moves from A to B', where $k_2 = (k_2)i < M$. Application of the RF pulse 117 causes relocation of the trajectory to the conjugate point C'. The data acquisition then proceeds as before, but in this case less lines in the dimension $k_2$ of k-space are required to arrive at the final end-point B. As in the case of full k-space acquisition, rephasing in both second and third dimensions is maximal as the k-trajectory crosses the origin of k-space; point A on Figure 3.

In order to minimize further phase errors and maximize the conjugate symmetry, it is desirable to arrange the k-space trajectory such that the point of rephasing in both second and third gradient directions, corresponding to point A on Figure 3, corresponds in time exactly with the "field echo" generated as a result of application of the 180° RF pulse 117 and indicated by the dashed line 120b. If the time between application of the first and second RF pulses, 116 and 117 respectively, is $t_1$, then the field echo will occur at the same time $t_1$ following the 180° RF pulse 117. Thus, for a reduced k-space acquisition, in order that the aforementioned maximal signal rephasing coincides with the peak of the field echo, the time $t_1$ before the 180° RF pulse 117 must be reduced appropriately.

Thus, partial k-space acquisition is achieved by omitting some of the encoding steps of either the positive or negative portions of k-space, but still sampling enough parts of k-space to estimate the phase variations in the image. Alternatively, the portion of k-space omitted may be in the orthogonal ($k_3$) direction, again still sampling enough symmetrical k-space to estimate the phase variations in the image.

Advantageously, the time saved in acquiring less than the entire data of k-space maybe utilized instead for:

(1) acquiring additional non-symmetric lines of data in k-space in order to increase the resolution of the image; or

(2) keeping the length of the total acquisition time as short as possible to reduce any motional artifacts or to reduce signal loss due to $T_2$ decay time.

In sum, for the reasons given below, it is often desirable to collect less than a full k-space data set in the x-direction.

(1) The number of $k_x$ lines collected is reduced, hence the data acquisition time is reduced. This results in more faithful representations of moving objects. Unfortunately, the fact that less data is acquired means that the signal-to-noise ratio (SNR) in the final image is reduced. However, this can be more than compensated by the following:

(2) Because data in the high speed image technique of the present invention is acquired following a 180° refocussing pulse, within the envelope of a spin echo, the time between the center of the spin echo envelope and the initial 90° exciting RF pulse is $2t_1$, and $t_1$ is the time between the initial 90° pulse and the 180° refocussing pulse. The maximum amplitude of the signals within the spin echo envelope decays as a result of $T_2$ relaxation, and the decay is an exponential function of $t_1$. Thus, the best SNR is obtained from the shortest $t_1$ values. In the full k-space acquisition, when the echo envelope peak corresponds in time with the central line ($k_x = 0$) of k-space, M lines are acquired before the center of the echo envelope, and M-1 lines after. If M lines take $t_M$ milliseconds to acquire, clearly $t_1$ cannot be less than $t_M$. However, if less than M lines are acquired before the center of the echo envelope, $t_M$ and hence $t_1$ can be reduced. Since the time between the initial 90° pulse and the center of the spin echo envelope is TWICE $t_1$, any time saving gains which are obtained as a result of partial k-space acquisition are effectively doubled in terms of the complete high-speed experiment. Also, since the peak of the spin echo envelope now occurs earlier, less $T_2$ signal decay occurs and hence SNR is higher.

The method for performing the partial k-space acquisition, as described above, involves a modification of the encoding gradients 120 and 130 in the pre-encoding interval between the 90°-180° RF pulse pair.

The reconstruction of partial k-space images in the present invention is accomplished in accordance with the following theory and algorithms:

### 1. Theory of reconstruction of images with slowly varying phases

The spatial distribution of an image can be described by a complex function F(x). Consider just a one-dimensional distribution (generalization for two-dimensional case is obvious). The density is given by magnitude of F(x).

Fourier transform of spatial distribution function

$$F_n = \sum_x F(x) \, e^{-ik_n x} \qquad (1)$$

represents time data obtained in 2 DFT-type NMR imaging experiments. In (1) $x = \frac{Lm}{N}$ (m = 0,...,N-1), N is the number of pixels, and $k_n = \frac{2\pi}{L}$, where L is the length of the imagined area. It follows from (1) that function $F_n$ is a periodical function of n with period of N. This allows to define $F_n$ outside of the range of time data obtained in an experiment.

Reversed Fourier transform of $F_n$ yields the spatial distribution function F(x):

$$F(x) = \frac{1}{N} \sum_{n=0}^{N-1} F_n \, e^{ik_n x} \qquad (2)$$

If F(x) is real then it can be restored using time data within only half of the k-space (Fourier domain):

$$F(x) = \frac{1}{N} \, Re \left( 2 \sum_{n=1}^{N/2} F_n \, e^{ik_n x} + F_o \right) \qquad (3)$$

If F(x) is not real but its phase is a slowly varying function in space, F(x) can be reconstructed from $F_n$ using just extra few Fourier harmonic in addition to half of the data in the k-space. The magnitude G(x) of F-(x) can be written as

$$G(x) = \phi(x)F(x) \qquad (4)$$

In the Fourier domain, this equation has the form:

$$G_n = \sum_{n'} \phi_{n'} F_{n-n'} \qquad (5)$$

Assume that the length 1 of $\phi(x)$ variation is much larger than pixel size L/N. Then only low spatial frequency harmonics of $\phi_{n'}$ with $|n'| \leq \frac{L}{l}$ are essential in (5) and the sum there can be reduced to

$$G_n = \sum_{|n'|<\Delta n} \phi_{n'} F_{n-n'} \qquad (6)$$

where $\frac{L}{l} < \Delta n << N$.

G(x) is a real function by definition. To restore it one only needs to know $G_n$ in the range $0 \leq n \leq N/2$. These $G_n$ can be found from (6) if $F_n$ is known in the range $-\Delta n \leq n \leq N/2 + \Delta n$ and $\phi_n$ is known in the range $-\Delta n \leq n \leq \Delta n$. Required $F_n$ must be obtained from an experiment. The following shows how $\phi_n$ can now be found from acquired $F_n$.

First introduce the function

$$\tilde{F}(x) = \frac{1}{N} \sum_{-\Delta n \leq n \leq \Delta n} F_n e^{ik_n x} \qquad (7)$$

$$= \frac{1}{N} \sum_{x'} F(x') \ S(x-x') = \frac{1}{N} \sum_{x'} \phi^{-1}(x') G(x') S(x-x') \cdot$$

where

$$S(x) = \sin \left[\frac{2\pi}{L} (\Delta n + 1/2) x \right] / \sin \frac{2\pi}{L} x \qquad (8)$$

Function S(x) has a large peak $S_o = 2 \Delta n + 1$ at x = 0. The width of the peak

$$\Delta x \sim \frac{L}{2\Delta n + 1} << L \quad .$$

Outside of the peak S(x) has much smaller oscillating values of order of units. Unless a significant periodical structure with length

$$\frac{L}{2\Delta n + 1}$$

is present in the image source, most of the contribution to the sum over x' in (7) comes from the area of x' from x - $\Delta$x to x + $\Delta$x.

Now replace argument x' in $\phi^{-1}$ (x') with x:

$$\tilde{F}(x) \cong \frac{1}{N} \phi^{-1}(x) \Sigma \ G(x')S(x-x') = \phi^{-1}(x) \ \tilde{G}(x). \qquad (9)$$

Function $\tilde{G}(x) = \frac{1}{N} \Sigma \ G(x')S(x-x')$ is a real function. $\phi(x)$ can be easily found now from (9):

$$\Phi(x) = \tilde{F}^*(x)/|\tilde{F}(x)| \qquad (10)$$

Equations (6), (7), and (10) give a solution to the problem of image reconstruction for images with slowly varying phases. A light interference effect can be observed sometimes while using this technique. It can happen when the image has a significant periodical structure of the length multiple to $L/2\Delta n + 1$ (see (8)).

2. Reconstruction algorithms.

The following is a description of two algorithms of image reconstruction based on formulas (6), (7), and (10). We assume that acquired data fill half of the k-space plus $\Delta n$ low frequency lines and the rest of the k-space is zeroed. To use (6) it is necessary to know also $\Delta n$ high frequency lines. However, in most practical cases it is possible to neglect few high frequency lines because they are usually very small. It is also assumed that the encoding within echoes corresponds to the horizontal direction.

Algorithm I

S.1 RFT (reversed Fourier transform) in the horizontal direction.
S.2 Create an image using $2\Delta n + 1$ low frequency lines.
S.3 Find phase function $\phi$ for S.2.
S.4 DFT (direct Fourier transform) of S.3 in the vertical direction.
S.5 Calculate $G_n$ ($n = 0$, N/2) using (6).
S.6 RFT on $G_n = \{G_o, 2G_n(n = 1, N/2), 0 (n = N/2 + , N-1)\}$
S.7 Take real part of S.6.

Algorithm II

S.1 RFT in the horizontal direction.
S.2 Create an image using $2\Delta n + 1$ low frequency lines.
S.3 Find phase function for S.2.
S.4 Create an image using all lines in time data.
S.5 Multiply S.4 by S.3.
S.6 DFT on S.5.
S.7 Double values of S.6 for lines $n = 1$, n/2 and set to zero lines $n = N/2 + 1$, N-1.
S.8 RFT on S.7.
S.9 Take real part of S.8.

Both algorithms I and II are functionally completely equivalent.

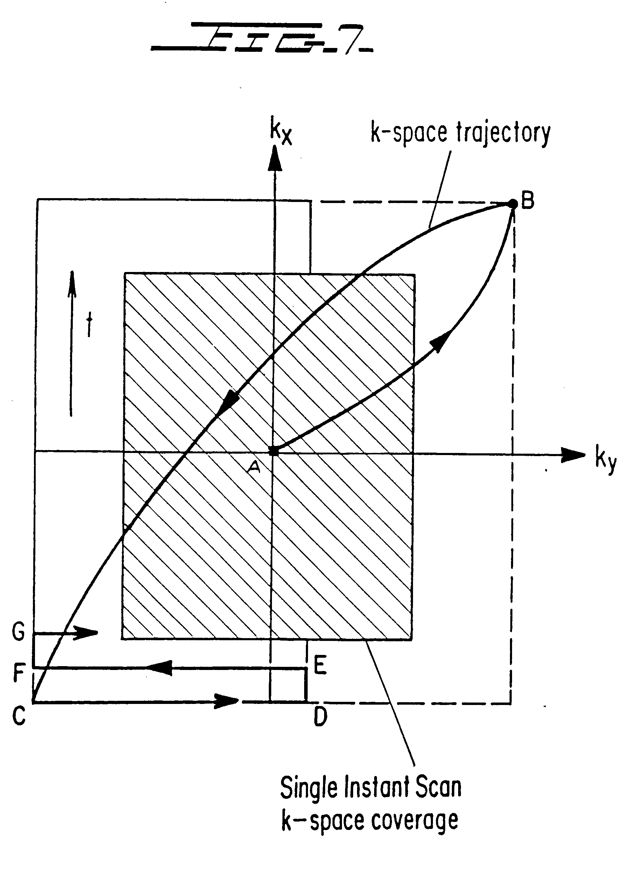

Although partial k-space acquisition has been described above primarily with respect to acquiring less than 100% of the phase encoded lines in the x-direction, it is equally possible to acquire less than 100% of the y dimension of k-space by similarly reducing the area of the pre-encoding $G_y$ gradient. Since the scan in the y direction of k-space takes only approximately 300 microseconds, no appreciable $T_2$ decay occurs. By shifting the $k_y$ scan about the origin as shown in Fig. 6, while collecting the same number of points in a partial $k_y$ scan and thus keeping the signal bandwidth the same, higher spatial frequencies may be described. This variant therefore produces a higher resolution image in "one shot", but with a lower SNR.

Mosaic Scan Technique

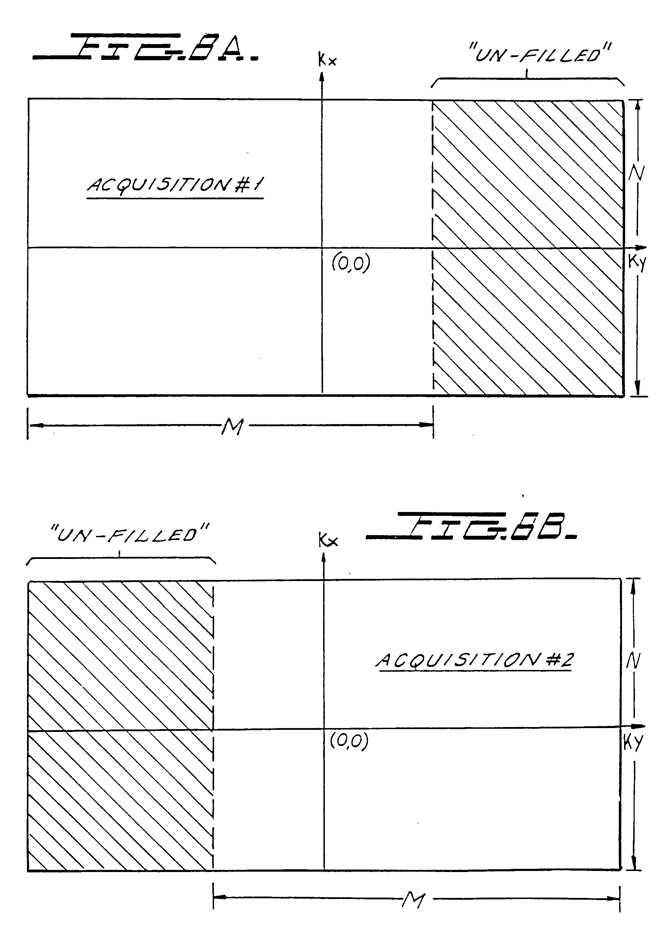

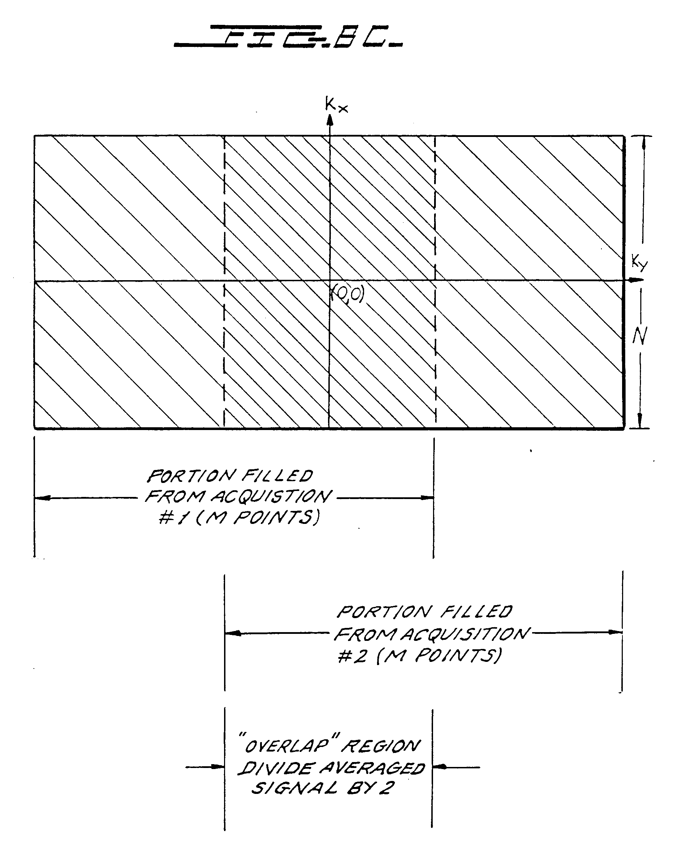

In situations where the body can be made motionless and enough time is made available to take more than "one shot", higher spatial frequencies can be described by splitting k-space into two, four or more portions, each of which is filled with a partial k-space acquisition. Figure 7 depicts this idea with a simple "2-Tile" Mosaic scan of k-space. The total area covered in each single acquisition remains substantially constant (a slightly greater coverage of $k_x$ is shown in Fig. 7) but is displaced by suitable pre-encoding between the 90° and 180° RF pulses, 116 and 117, respectively, of the pulse sequence shown in Fig. 2. As shown in Fig. 8A-8C, two acquisitions are sufficient to fill the desired area and increase resolution. The acquired k-space portions form a patchwork or "mosaic", which is pieced together prior to Fourier transformation. The resultant image is thus of higher spatial resolution than one obtained in a single high speed acquisition of the invention (termed "Instant Scan"). An overlap between the "tiles" as shown in Fig. 8C is useful as it allows for the accurate joining of the k-space sections, but is not absolutely necessary.

The reason such a straight forward extension of k-space coverage is possible is that the $k_y$ scan takes just 312 microseconds. Over such a short time there is negligible $T_2^*$ decay and thus the transfer function is essentially flat.

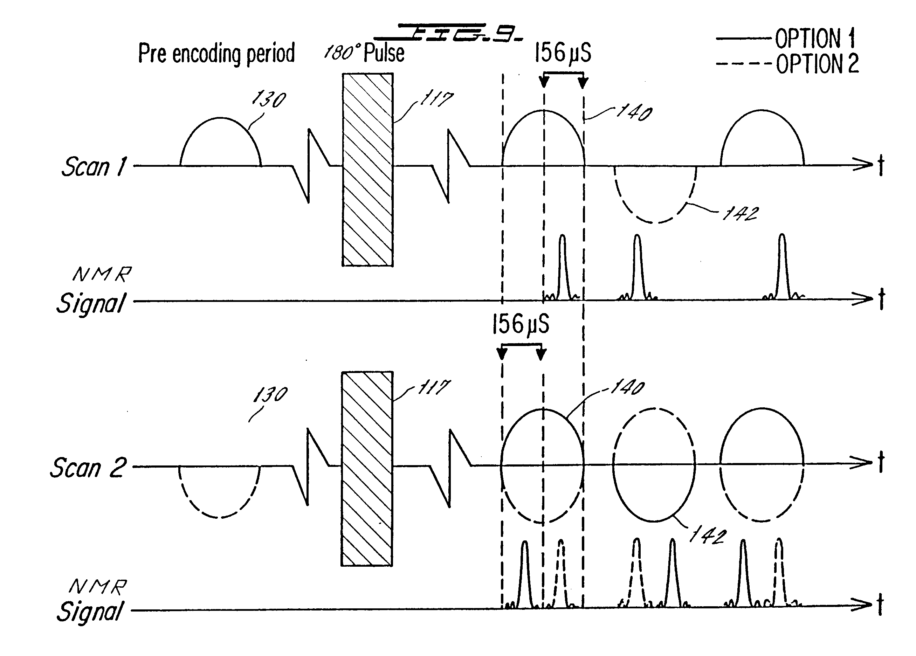

Fig. 9 shows the pulse sequence and signal for two such consecutive scans, the first labeled Scan 1, shown in the absence of $G_x$, depicts the displaced echo obtained by suitable pre-encoding. There are two choices for Scan 2, both shown, the first is to scan $k_y$ in the same direction on each $k_x$ line as in Scan 1, or second, to scan in the opposite direction which, for the 2-Tile case, results in $k_y = 0$ being acquired at the same time relative to the start of each scan. In either case, each piece of $k_y$ line is always displaced less than ± 156 microseconds from the center of the gradient pulse, allowing many "tiles" to be simply stuck together, each representing higher and higher spatial frequencies in the image.

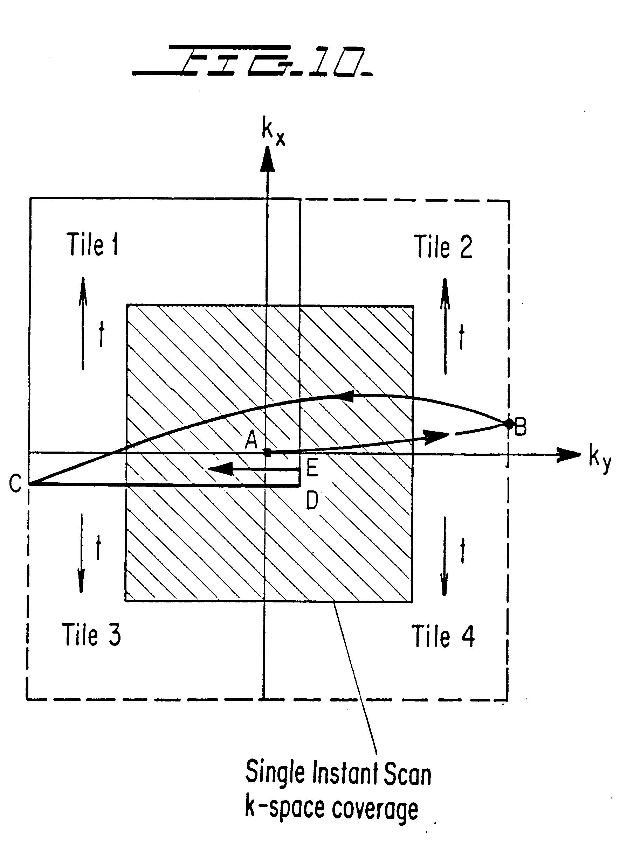

As mentioned previously, the number of points obtained in $k_x$ and $k_y$ in a single acquisition is 64 x 128, respectively. A factor approaching two in both the x and y directions (representing a four-fold reduction in pixel area) may be achieved by a 4-Tile Mosaic Scan, in which k-space acquisitions from each quadrant of k-space are pieced together, as shown in Fig. 10.

## MESH Scan Technique

One characteristic of Mosaic Scan is that each constituent acquisition has an asymmetric $T_2$ decay associated with it, and when the acquisitions are mosaicked together this $T_2$ decay forms a discontinuous function. This decay is most appreciable in the $k_x$ dimension, in which acquisitions occur in real time. One way to overcome this problem, if $T_2$ decay is relatively short and field inhomogeneities are not large, is to use a 4-Tile Mosaic Scan and reverse the direction of the $G_x$ gradient applied during $T_{acq}$ in opposite portions of k-space in the x-direction as shown in Fig. 10. The result is that $T_2$ decay in the x-direction is symmetric about the $k_x = 0$ by scanning in opposite gradients, first along $+k_x$ and second along $-k_x$. The initial trajectory A-B-C stays around $k_x = 0$. The field echo generated by the 180° pulse appears at approximately $+k_x/2$, so 4-Tile Mosaic Scan is preferred for high homogeneity situations.

Alternatively, where $T_2$ is relatively long and field inhomogeneities are higher, the $k_x$ dimension may be filled by interleaving or "meshing" lines from subsequent acquisitions while the $k_y$ dimension is filled by mosaicking, called MESH (Mosaicked-Echo Scan Hybrid), shown in Fig. 10. Interleaving in the $k_x$ dimension ensures that the $T_2$ decay is a continuous function of $k_x$.

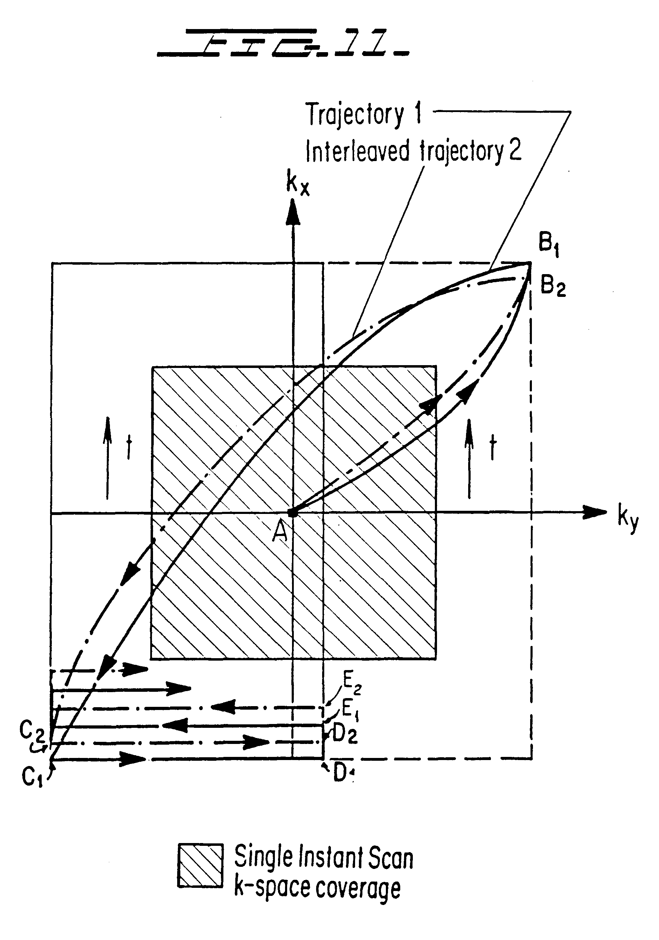

Referring to Fig. 11, in the case where coverage is doubled, the initial trajectory $A-B_1-C_1$ proceeds to the edge of k-space. By doubling the pulsed gradient $G_x$, the step DE is doubled and the whole desired $k_x$ area is covered in a single scan but at half the density. The subsequent scan $A-B_2-C_2$ along $k_x$ commences with a slight offset and interleaves or "MESHes" the previous coverage. In this situation, the $T_2$ decay is represented identically as in the full k-space acquisition with a centered and symmetric field echo about $k_x = 0$. A slight asymmetry may result for short $T_2$, but in reality it is the field echo, especially at high field, that is the major concern and needs to be made symmetric. MESH does require the use of a stronger $G_x$ gradient, but this is actually not a problem, as this gradient is always significantly weaker than the y-gradient. Further, by using MESH, a factor greater than two can be obtained for the increase in $k_x$ coverage.

In both the Mosaic and MESH techniques, because the bandwidth of the signal stays fixed, the averaging effect of the scans ensures that the SNR reduces in proportion to the square root of the reduction in pixel area. Thus, to achieve equivalent SNR to a single-shot image, only a moderate amount of averaging is necessary. For example, for a 4-Tile mosaic or MESH, it would be necessary to perform 4 averages or a total of 16 scan altogether to regain the SNR of the single lower resolution acquisition.

The use of multi-slice imaging techniques in Mosaic Scan and MESH, in which multiple planes may be acquired one immediately after the other, allows for very rapid three dimensional imaging.

Direct oblique plane scanning using Mosaic Scan and MESH may be accomplished by performing the magnetic resonance studies with non-orthogonal gradients as discussed earlier.

In order to eliminate the chemical shift problem, either of the two following methods may be followed. Referring to Figure 4, in the first method, a 90° RF suppression pulse 180 having a carrier frequency equivalent to the resonant frequency of one of the chemical moieties (water or fat) and with a bandwidth just wide enough to cover any broadening due to $T_2^*$ is applied prior to the application of the first (slice-selection) gradient.

A subsequent gradient pulse of sufficient magnitude will cause the phase response of the selected moiety to be shifted in k-space such that the selected moiety will completely be removed from the relevant portion of k-space and will not read out when the pulse sequence of Figure 2 is applied. This type of suppression sequence is known in the art and requires no further explanation.

A second method for eliminating chemical shift is to reduce the frequency spectrum of the 180° rephasing pulse such that it is just wide enough to cover the resonant frequency of the desired chemical moiety. Thus, the undesired moiety will not be rephased (i.e., not shifted diagonally in k-space in Figure 3) and will be moved out of the relevant portion of k-space (and produce no readout) during the sampling period. Such a method is disclosed in a paper by Peter M. Joseph entitled "A Spin Echo Chemical Shift MR Imaging Technique" published in the Journal of Computer Assisted Tomography, 9(4) : 651-658, July/August, Rowen Press, New York (1985).

## Claims

1. A method of deriving image information at high speed from an object using nuclear magnetic resonance signals, comprising the steps of:

   (a) subjecting an object to a continuous static magnetic field along an axis, said magnetic field having a strength between about 0.5 and 5 Tesla;

   (b) exciting nuclear spins in a selected plane of the object by applying to the object a first radio frequency pulse together with a first magnetic field gradient perpendicular to said plane comprising a slice selection gradient, such that free induction decay signals are produced by said excited nuclear spins in said plane;

   (c) applying to the object an encoding sequence comprising a second magnetic field gradient of a predetermined magnitude having a direction parallel to said plane together with a third magnetic field gradient of a predetermined magnitude having a direction also parallel to said plane and perpendicular to said second gradient;

   (d) applying to said object a further slice selection gradient such that the total dephasing effect of the slice selection gradient applied in step (b) is as close to zero as possible;

   (e) applying a sequence comprising a series of alternate applications to the object, respectively in time, of said second magnetic field gradient defining phase encoding gradients and said third magnetic field gradient defining readout gradients, said sequence of second and third magnetic field gradients being completed within a period of time less than about 100 milliseconds, resulting in a trajectory through a predetermined portion of k-space based upon said predetermined magnitudes of said second and third magnetic fields applied to the object in said encoding sequence of step (c); and

   (f) acquiring data to form a magnetic resonance image by sampling nuclear magnetic resonance signals output from said object during the application of said readout gradients to form a series of data values in the time domain, formatting said time domain data into modified data estimating the spatial frequencies of the object and transforming said modified data into spatial domain data for presentation as an image of the object.

2. The method of claim 1, further comprising the step of applying a second radio frequency pulse to the object between steps (c) and (d).

3. The method of claim 2, wherein the length of said second radio frequency pulse is selected to contain only a narrow band of frequency components, whereby the application of said second radio frequency pulse causes only one of two chemically shifted moieties to rephase.

4. The method of claim 2 or claim 3, wherein the slice selection gradient recited as being applied in step (d) is applied prior to said second radio frequency pulse with an opposite polarity.

5. A method according to any of claims 1 to 4, further comprising a suppression period prior to step (b) comprising the application of a chemical shift suppression pulse sequence comprising the following steps:

   (i) applying a radio frequency pulse to the nuclear spins in the absence of any magnetic field gradients wherein the bandwidth of said pulse substantially encompasses the shifted moieties and the central frequency of said pulse lies at the same frequency as the line to be suppressed;

   (ii) applying a magnetic field gradient having substantially more dephasing effect than any of the first, second or third gradients;

   (iii) repeating step (b) by applying another radio frequency pulse together with a slice-selection gradient; and

   (iv) repeating step (d) by applying a further slice-selection gradient for substantially eliminating dephasing effects.

6. A method of according to any of claims 2 to 4, or claim 5 when dependant on any of claims 2 to 4, wherein said second radio frequency pulse has an equal amount of magnetic field gradient applied before and after it for the purpose of destroying subsequent signal of any spins erroneously excited by imperfections in said second radio frequency pulse.

7. A method according to any of claims 2 to 4 or 6, or claim 5 when dependant on any of claims 2 to 4, wherein said second radio frequency pulse is a spatially selective pulse and is applied in conjunction with magnetic field gradient in any direction.

8. A method according to any of claims 2 to 4, 6 or 7, or claim 5 when dependant on any of claims 2 to 4, wherein said second radio frequency pulse is a broad band pulse having a wider frequency spectrum than the unmodified frequency spectrum of the whole image plane.

9. A method according to any of the preceding claims, wherein said phase encoding and readout gradients are applied partially overlapping in time, said readout gradients being applied as a continuous wave approximately sinusoidal in form, and wherein the data which is acquired during the period when said readout gradients and phase encoding gradients overlap is deleted prior to said transformation.

10. A method according to any of the preceding claims, comprising the further step of taking a complex sample of the receiver baseline level before the application of the first radio frequency pulse and using it to correct the baseline offset of the subsequently acquired data.

11. A method according to any of the preceding claims, wherein said first radio frequency pulse comprises a substantially 90° radio frequency pulse.

12. A method according to any of claims 2 to 4, 6 to 8, or 5, 8, 9, or 10 when dependent on any of claims 2 to 4, wherein said second radio frequency pulse comprises a substantially 180° radio frequency pulse.

13. A method according to any of the preceding claims, wherein the encoding sequence and the phase-encoding gradient applied are such that more than 50% of k-space is sampled in the direction of said phase-encoding gradient, the symmetric parts of k-space sampled being sufficient to adequately represent the phase of the image.

14. A method according to any of the preceding claims, wherein the encoding sequence and the readout gradient applied are such that more than 50% of k-space is sampled in the direction of said readout gradient, the symmetric parts of k-space sampled being sufficient to adequately represent the phase of the image.

15. A method according to any of the preceding claims, wherein the encoding sequence and the gradients applied are such that while only a portion of k-space is sampled, the same number of points are collected as in complete sampling of k-space, so that spatial frequency response is increased while signal bandwidth is maintained.

16. The method of claim 15, wherein at least two acquisitions are performed on different portions of k-space, the acquired portions being pieced together to form a continuous coverage of k-space in a k-space mosaic prior to transformation.

17. The method of claim 15, wherein at least four overlapping or abutting acquisitions are performed, one in each quadrant of k-space, the acquired portions being pieced together in a k-space mosaic prior to transformation.

18. The method of claim 15, wherein a first set of two overlapping or abutting acquisitions are performed on opposite sides of k-space in the direction of the readout gradient, followed by a second set of overlapping or abutting acquisitions performed in the direction of the readout gradient, said second set of acquisitions being interleaved with said first set of acquisitions in the direction of the phase-encoding gradient.

**Patentansprüche**

14

EP 0 270 320 B1

1. Verfahren zur Ableitung von Abbildungsinformation mit hoher Geschwindigkeit von einem Objekt unter Verwendung magnetischer Kernresonanzsignale, mit den folgenden Schritten:

(a) Aussetzen eines Objektes einem kontinuierlichen statischen Magnetfeld entlang einer Achse, wobei das Magnetfeld eine Feldstärke zwischen ungefähr 0,5 und 5 Tesla aufweist,

(b) Erregen von Kernspins in einer ausgewählten Ebene des Objektes dadurch, daß dem Objekt ein erster Hochfrequenzimpuls zusammen mit einem ersten Magnetfeldgradienten senkrecht zu der Ebene zugeführt wird, der einen Schnittauswahlgradienten darstellt, derart daß freie Induktionsabklingsignale durch die erregten Kernspins in der Ebene erzeugt werden,

(c) Zuführen einer Codierungsfolge an das Objekt, wobei die Codierungsfolge einen zweiten Magnetfeldgradienten mit einer vorgegebenen Größe und einer Richtung parallel zu der Ebene zusammen mit einem dritten Magnetfeldgradienten mit einer vorgegebenen Größe umfaßt, dessen Richtung ebenfalls parallel zu der Ebene und senkrecht zu dem zweiten Gradienten ist,

(d) Zuführen eines weiteren Schnittauswahlgradienten an das Objekt derart, daß der Gesamt-Phasenverschiebungseffekt des im Schritt (b) zugeführten Schnittauswahlgradienten so nahe wie möglich bei Null liegt,

(e) Anwenden einer Folge, die eine Reihe von zeitlich abwechselnden Zuführungen des die Phasencodierungsgradienten definierenden zweiten Magnetfeldgradienten und des Auslesegradienten definierenden dritten Magnetfeldgradienten an das Objekt umfaßt, wobei die Folge von zweiten und dritten Magnetfeldgradienten innerhalb einer Zeitepriode von weniger als ungefähr 100 Millisekunden vollendet wird, was zu einer Bahn durch einen vorgegebenen Teil des k-Raumes auf der Grundlage der vorgegebenen Größen der zweiten und dritten dem Objekt in der Codierungsfolge des Schrittes (c) zugeführten Magnetfelder führt, und

(f) Erfassen von Daten zur Bildung einer magnetischen Kernresonanz-Abbildung durch Abtasten magnetischer Kernresonanzsignale, die von dem Objekt während des Zuführens der Auslesegradienten abgegeben werden, um eine Serie von Datenwerten im Zeitbereich zu bilden, Formatieren der Zeitbereichsdaten in modifizierte Daten, die die Raumfrequenzen des Objektes abschätzen, und Transformieren der modifizierten Daten in Raumbereichsdaten zur Darbietung als eine Abbildung des Objektes.

2. Verfahren nach Anspruch 1, das weiterhin den Schritt der Zuführung eines zweiten Hochfrequenzimpulses an das Objekt zwischen den Schritten (c) und (d) umfaßt.

3. Verfahren nach Anspruch 2, bei dem die Länge des zweiten Hochrequenzimulses so ausgewählt ist, daß er lediglich ein schmales Band von Frequenzkomponenten enthält, wodurch die Zuführung des zweiten Hochfrequenzimpulses eine Phasenrückverschiebung lediglich eines von zwei chemisch verschobenen Bestandteilen hervorruft.

4. Verfahren nach Anspruch 2 oder 3, bei dem der als im Schritt (d) zugeführt genannte Schnittauswahlgradient vor dem zweiten Hochfrequenzimpuls mit einer entgegengestzten Polarität zugeführt wird.

5. Verfahren nach einem der Ansprüche 1 bis 4, das weiterhin eine Unterdrückungsperiode vor dem Schritt (b) umfaßt, die die Zuführung einer die chemische Verschiebung unterdrückenden Impulsfolge umfaßt, mit den folgenden Schritten:

(i) Zuführen eines Hochfrequenzimpulses an die Kernspins bei Fehlen irgendwelcher Magnetfeldgradienten, worin die Bandbreite des Impulses im wesentlichen die verschobenen Bestandteile umfaßt und die Mittelfrequenz des Impulses bei der gleichen Frequenz liegt, wie die zu unterdrückende Linie,

(ii) Zuführen eines Magnetfeldgradienten mit einem erheblich größeren Phasenverschiebungseffekt als einer der ersten, zweiten oder dritten Gradienten,

(iii) Wiederholen des Schrittes (b) durch Zuführen eines weiteren Hochfrequenzimpulses zusammen mit einem Schnittauswahlgradienten, und

(iv) Wiederholen des Schrittes (d) durch Zuführen eines weiteren Schnittauswahlgradienten, um im wesentlichen Phasenverschiebungseffekte zu beseitigen.

6. Verfahren nach einem der Ansprüche 2 bis 4 oder Anspruch 5 unter Rückbeziehung auf einen der Ansprüche 2 bis 4, bei dem ein gleiches Ausmaß an Magnetfeldgradienten vor und nach dem zweiten Hochfrequenzimpuls zugeführt wird, um ein nachfolgendes Signal von irgendwelchen Spins zu vernich-

15

ten, die in fehlerhafter Weise durch Unvollständigkeiten des zweiten Hochfrequenzimpulses erregt wurden.

7. Verfahren nach einem der Ansprüche 2 bis 4 oder 6 oder Anspruch 5 unter Rückbeziehung auf einen der Ansprüche 2 bis 4, bei dem der zweite Hochfrequenzimpuls ein räumlich selektiver Impuls ist und zusammen mit einem Magnetfeldgradienten in irgendeiner Richtung zugeführt wird.

8. Verfahren nach einem der Ansprüche 2 bis 4, 6 oder 7 oder Anspruch 5 unter Rückbeziehung auf einen der Ansprüche 2 bis 4, bei dem der zweite Hochfrequenzimpuls ein Breitbandimpuls mit einem breiteren Frequenzspektrum als das unmodifisierte Frequenzspektrum der gesamten Abbildungsebene ist.

9. Verfahren nach einem der vorhergehenden Ansprüche, bei dem die Phasencodierung- und Auslesegradienten teilweise zeitlich überlappend zugeführt werden, wobei die Auslesegradienten als eine Dauerschwingung angenähert sinusförmiger Form zugeführt werden, und bei dem die Daten, die während der Periode, während der sich die Auslesegradienten und Phasencodierungsgradienten überlappen, vor der Transformation gelöscht werden.

10. Verfahren nach einem der vorhergehenden Ansprüche, das den weiteren Schritt der Gewinnung einer komplexen Abtastprobe des Empfänger-Grundlinienpegels vor der Zuführung des ersten Hochfrequenzimpulses und die Verwendung dieses Grundlinienpegels zur Korrektur der Grundlinienversetzung der nachfolgend erfaßten Daten umfaßt.

11. Verfahren nach einem der vorhergehenden Ansprüche, bei dem der erste Hochfrequenzimpuls einen Hochfrequenzimpuls von im wesentlichen 90° umfaßt.

12. Verfahren nach einem der Ansprüche 2 bis 4, 6 bis 8 oder 5, 8, 9 oder 10 unter Rückbeziehung auf einen der Ansprüche 2 bis 4, bei dem der zweite Hochfrequenzimpuls einen Hochfrequenzimpuls von im wesentlichen 180° umfaßt.

13. Verfahren nach einem der vorhergehenden Ansprüche, bei dem die zugeführte Codierungsfolge und der zugeführte Phasencodierungsgradient derart sind, daß mehr als 50% des k-Raumes in der Richtung des Phasencodierungsgradienten abgetastet wird, wobei die symmetrischen Teile des abgetasteten k-Raumes ausreichend sind, um die Phase der Abildung in ausreichender Weise darzustellen.

14. Verfahren nach einem der vorhergehenden Ansprüche, bei dem die zugeführte Codierungsfolge und der zugeführte Auslesegradienten derart sind, daß mehr als 50% des k-Raumes in der Richtung des Auslesegradienten abgetastet werden, wobei die symmetrischen Teile des abgetasteten k-Raumes ausreichend sind, um die Phase der Abbildung in angemessener Weise darzustellen.

15. Verfahren nach einem der vorhergehenden Ansprüche, bei dem die zugeführte Codierungsfolge und die zugeführten Gradienten derart sind, daß obwohl lediglich ein Teil des k-Raumes abgetastet wird, die gleiche Anzahl von Punkten wie in einer vollständigen Abtastung des k-Raumes gesammelt wird, so daß das Raumfrequenz-Ansprechverhalten vergrößert wird, während die Signalbandbreite beibehalten wird.

16. Verfahren nach Anspruch 15, bei dem zumindestens zwei Erfassungen an unterschiedlichen Teilen des k-Raumes durchgeführt werden, wobei die erfaßten Teile stückweise zusammengesetzt werden, um eine kontinuierliche Überdeckung des k-Raumes in einem k-Raum-Mosaik vor der Transformation zu bilden.

17. Verfahren nach Anspruch 15, bei dem zumindestens vier überlappende oder aneinander anstoßende Erfassungen, eine in jedem Quadranten des k-Raumes durchgeführt werden, wobei die erfaßten Teile stückweise in einem k-Raum-Mosaik vor der Transformation zusammengesetzt werden.

18. Verfahren nach Anspruch 15, bei dem ein erster Satz von zwei überlappenden oder aneinander anstoßenden Erfassungen auf gegenüberliegenden Seiten des k-Raumes in der Richtung des Auslesegradienten, gefolgt von einem zweiten Satz von überlappenden oder aneinander anstoßenden Erfassungen ausgeführt wird, die in der Richtung des Auslesegradienten ausgeführt werden, wobei der zweite Satz von Erfassungen mit dem ersten Satz von Erfassungen in der Richtung des Phasencodierungsgradienten miteinander verzahnt wird.

## Revendications

1. Procédé d'imagerie à grande vitesse d'un objet en utilisant des signaux de résonance magnétique nucléaire comprenant les étapes suivantes :

   (a) soumission d'un objet à un champ magnétique statique continu le long d'un axe, ledit champ magnétique ayant une intensité comprise entre 0,5 et 5 Tesla ;

   (b) excitation des spins nucléaires dans un plan sélectionné de l'objet en appliquant à l'objet une première impulsion à radiofréquence en même temps qu'un premier gradient de champ magnétique perpendiculaire dudit plan comprenant un gradient de sélection de tranche, de façon que des signaux d'affaiblissement d'induction libre soient produits par lesdits spins nucléaires excités dans ledit plan ;

   (c) application à l'objet d'une séquence de codage comprenant un second gradient de champ magnétique d'une amplitude prédéterminée ayant une direction parallèle audit plan en même temps qu'un troisième gradient de champ magnétique d'une amplitude prédéterminée ayant une direction également parallèle audit plan et perpendiculaire audit second gradient ;

   (d) application audit objet d'un autre gradient de sélection de tranche de façon que l'effet total de déphasage du gradient de sélection de tranche appliqué à l'étape (b) soit aussi proche de zéro que possible ;

   (e) application d'une séquence comprenant une série d'applications alternées à l'objet, respectivement dans le temps dudit second gradient de champ magnétique définissant des gradients de codage de phase et ledit troisième gradient de champ magnétique définissant des gradients de lecture, ladite séquence des second et troisième gradients de champ magnétique étant terminée dans une période de temps inférieure à 100 millisecondes, en aboutissant à une trajectoire passant par une partie prédéterminée de l'espace k basée sur lesdites amplitudes prédéterminées desdits second et troisième champs magnétiques appliqués à l'objet dans ladite séquence de codage de l'étape (c) ; et

   (f) acquisition des données pour former une image par résonance magnétique en échantillonnant les signaux de résonance magnétique nucléaire délivrés par ledit objet pendant l'application desdits gradients de lecture pour former une série de valeurs de données dans le domaine du temps, le formatage desdites données du domaine du temps pour les transformer en données modifiées estimatives des fréquences spatiales de l'objet et la transformation desdites données modifiées en données du domaine spatial pour la présentation sous forme d'une image de l'objet.

2. Procédé selon la revendication 1, comprenant en outre l'étape d'application d'une seconde impulsion à radiofréquence à l'objet entre les étapes (c) et (d).

3. Procédé selon la revendication 2, dans lequel la longueur de ladite seconde impulsion à radiofréquence est sélectionnée pour contenir seulement une bande étroite des composantes de fréquence, de façon que l'application de ladite seconde impulsion à radiofréquence provoque la remise en phase d'une seule des deux parties chimiquement décalées.

4. Procédé selon la revendication 2 ou 3, dans lequel le gradient de sélection des tranches indiqué ci-dessus comme ayant été appliqué à l'étape (d) est appliqué avant ladite seconde impulsion à radiofréquence avec une polarité opposée.

5. Procédé selon l'une quelconque des revendications 1 à 4, comprenant en outre une période de suppression précédant l'étape (b) comprenant l'application d'une séquence d'impulsion de suppression du décalage chimique comportant les étapes suivantes :

   (i) application d'une impulsion à radiofréquence aux spins nucléaires en l'absence de tout gradient de champ magnétique de façon que la largeur de bande de ladite impulsion englobe sensiblement les parties décalées et que la fréquence centrale de ladite impulsion se situe à la même fréquence que la ligne à supprimer ;

   (ii) application d'un gradient de champ magnétique ayant sensiblement un effet de déphasage plus important que l'un quelconque des premier, second ou troisième gradients ;

17

(iii) répétition de l'étape (b) en appliquant une autre impulsion à radiofréquence en même temps qu'un gradient de sélection de tranche ; et

(iv) répétition de l'étape (d) en appliquant un autre gradient de sélection de tranche pour éliminer sensiblement les effets de déphasage.

6. Procédé selon l'une quelconque des revendications 2 à 4, ou selon la revendication 5 lorsqu'elle est dépendante de l'une quelconque des revendications 2 à 4, dans lequel ladite seconde impulsion à radiofréquence comprend un gradient de champ magnétique de même amplitude appliqué avant et après elle dans le but de détruire les signaux ultérieurs des spins éventuellement excités par erreur par des imperfections dans ladite seconde impulsion à radiofréquence.

7. Procédé selon l'une quelconque des revendications 2 à 4 ou 6, ou selon la revendication 5 lorsqu'elle est dépendante de l'une quelconque des revendications 2 à 4, dans lequel ladite seconde impulsion à radiofréquence est une impulsion sélective dans l'espace et se trouve appliquée en liaison avec un gradient de champ magnétique dans une direction quelconque.

8. Procédé selon l'une quelconque des revendications 2 à 4, 6 ou 7, ou selon la revendication 5 lorsqu'elle est dépendante de l'une quelconque des revendications 2 à 4, dans lequel ladite seconde impulsion à radiofréquence est une impulsion à large bande ayant un spectre de fréquence plus large que le spectre de fréquence non modifié de la totalité du plan image.

9. Procédé selon l'une quelconque des revendications précédentes, dans lequel lesdits gradients de codage de phase et de lecture sont appliqués en chevauchant partiellement dans le temps, lesdits gradients de lecture étant appliqués sous forme d'une onde continue de forme sensiblement sinusoïdale, et dans lequel les données qui sont acquises pendant la période lorsque lesdits gradients de lecture et lesdits gradients de codage de phase empiètent l'un sur l'autre, sont détruites avant ladite transformation.

10. Procédé selon l'une quelconque des revendications précédentes, comprenant l'étape supplémentaire consistant à prélever un échantillon complexe au niveau de la ligne de base du récepteur avant l'application de la première impulsion à radiofréquence et à utiliser cet échantillon pour corriger le décalage de la ligne de base des données acquises ultérieurement.

11. Procédé selon l'une quelconque des revendications précédentes, dans lequel ladite première impulsion à radiofcéquence, est constituée par une impulsion à radiofréquence de sensiblement 90°.

12. Procédé selon l'une quelconque des revendications 2 à 4, 6 à 8 ou 5, 8, 9 ou 10 lorsqu'elles dépendent de l'une quelconque des revendications 2 à 4, dans lequel ladite seconde impulsion à radiofréquence est constituée par une impulsion à radiofréquence de sensiblement 180°.

13. Procédé selon l'une quelconque des revendications précédentes, dans lequel la séquence de codage et le gradient de codage de phase appliqué sont tels que plus de 50 % de l'espace k est échantillonné dans la direction dudit gradient de codage de phase, les parties symétriques de l'espace k échantillonné étant suffisantes pour représenter de façon adéquate la phase de l'image.

14. Procédé selon l'une quelconque des revendications précédentes, dans lequel la séquence de codage et le gradient de lecture appliqué sont tels que plus de 50 % de l'espace k est échantillonné dans la direction dudit gradient de lecture, les parties symétriques de l'espace k échantillonné étant suffisantes pour représenter la phase de l'image de manière adéquate.

15. Procédé selon l'une quelconque des revendications précédentes, dans lequel la séquence de codage et les gradients appliqués sont tels que même si une partie seulement de l'espace k est échantillonné, le même nombre de points est collecté que dans l'échantillonnage complet de l'espace k, de manière que la réponse en fréquence spatiale soit accrue alors que la largeur de bande du signal est maintenue.

16. Procédé selon la revendication 15, dans lequel les deux acquisitions au moins sont effectuées en différentes parties de l'espace k, les parties actives étant assemblées pour former une couverture continue de l'espace k selon une mosaïque de l'espace k avant la transformation.

17. Procédé selon la revendication 15, dans lequel quatre acquisitions au moins empiétant ou en butée sont effectuées, l'une dans chaque quadrant de l'espace k, les parties acquises étant assemblées suivant une mosaïque de l'espace k avant transformation.

18. Procédé selon la revendication 15, dans lequel un premier ensemble de deux acquisitions empiétant ou en butée est effectué sur les côtés opposés de l'espace k dans la direction du gradient de lecture, suivi par un second ensemble d'acquisitions empiétant ou en butée effectué dans la direction du gradient de lecture, ledit second ensemble d'acquisitions étant entrelacé avec ledit premier ensemble d'acquisitions dans la direction du gradient de codage de phase.

FIG.1.

_FIG. 2._

FIG.3.

$M \times N$
SPATIAL FREQ. DOMAIN

$$A = \mathcal{R}_2 , \mathcal{R}_3 = (0, 0)$$
$$B = \mathcal{R}_2 , \mathcal{R}_3 = (-M, -\frac{N}{2})$$
$$C = \mathcal{R}_2 , \mathcal{R}_3 = (M, \frac{N}{2} - 1)$$

_FIG. 4._

2ND GRAD
(PHASE ENCODING)

3RD GRAD
(READOUT)

NMR
SIGNAL

ACQUISTION
PULSES

150

160

200

X4

APPLY PHASE ENCODING &
READOUT GRADIENTS-
COLLECT DATA

FIG.5.

EP 0 270 320 B1

$\equiv$$\varGamma\varPi\varXi$. 6.

"UNFILLED"

FIG. 7.

k-space trajectory

Single Instant Scan
k-space coverage

_FIG.8A._

"UN-FILLED"

k_x

ACQUISITION #1

(0,0)

K_y

N

M

_FIG.8B_

"UN-FILLED"

K_x

ACQUISITION #2

(0,0)

K_y

N

M

EP 0 270 320 B1

FIG. 8C.

PORTION FILLED
FROM ACQUISITION
#1 (M POINTS)

PORTION FILLED
FROM ACQUISITION
#2 (M POINTS)

"OVERLAP" REGION
DIVIDE AVERAGED
SIGNAL BY 2

_FIG.9._

Pre encoding period  180°Pulse  156 μS

OPTION 1
OPTION 2

Scan 1

NMR Signal

156 μS

Scan 2

NMR Signal

FIG.10.

Single Instant Scan
k-space coverage

FIG.11.

Trajectory 1
Interleaved trajectory 2

$k_x$

$B_1$
$B_2$

$t$

$A$

$t$

$k_y$

$E_2$
$E_1$

$C_2$
$C_1$

$D_2$
$D_1$

Single Instant Scan
k-space coverage